# EUROPEAN PATENT APPLICATION

(11) **EP 4 207 495 A1**
(43) Date of publication of application: **05.07.2023**
(21) Application number: 20954784.3
(22) Date of filing: 28.09.2020
(51) Int. Cl.: H01Q 21/00

(54) **ANTENNA ARRAY, APPARATUS, AND WIRELESS COMMUNICATION DEVICE**

(71) Applicant: Huawei Technologies Co., Ltd., Shenzhen, Guangdong 518129 (CN)
(72) Inventor: PENG, Jie, Shenzhen, Guangdong 518129 (CN); WANG, Weifeng, Shenzhen, Guangdong 518129 (CN); YAO, Amin, Shenzhen, Guangdong 518129 (CN); ZHANG, Yue, Shenzhen, Guangdong 518129 (CN)
(74) Representative: Isarpatent
(86) International application number: PCT/CN2020/118586
(87) International publication number: WO 2022/061937

(57) **Abstract**

Embodiments of this application provide an antenna array, an apparatus, and a wireless communication device, and relate to the field of antenna technologies. The antenna array includes: a plurality of subarrays, where a feed point and at least one radiating element are disposed on each subarray, the plurality of subarrays are arranged in a first direction and a second direction, the first direction is perpendicular to the second direction, the feed points of the plurality of subarrays are located on a same straight line in the first direction, and the feed points of the plurality of subarrays are located on a same straight line in the second direction; and in the first direction, subarrays to which feed points on a same straight line belong are located in a same row, and in the second direction, subarrays to which feed points on a same straight line belong are located in a same column. Each subarray has a phase center, phase centers of subarrays in at least one row of subarrays in the antenna array are not on a same straight line, and/or phase centers of subarrays in at least one column of subarrays in the antenna array are not on a same straight line.

## Description

### TECHNICAL FIELD

This application relates to the field of antenna technologies, and in particular, to an antenna array, an apparatus, and a wireless communication device.

### BACKGROUND

A plurality of radiating elements are arranged in an array manner, to form an antenna array. Each radiating element may also be referred to as an array element (Array Element).

Generally, a phase shifter is used to control a phase of the radiating element. When there are a large quantity of radiating elements in the antenna array, a plurality of phase shifters are needed. To reduce a quantity of phase shifters and simplify a control circuit, several radiating elements usually share one phase shifter, and a plurality of radiating elements that share one phase shifter form one subarray.

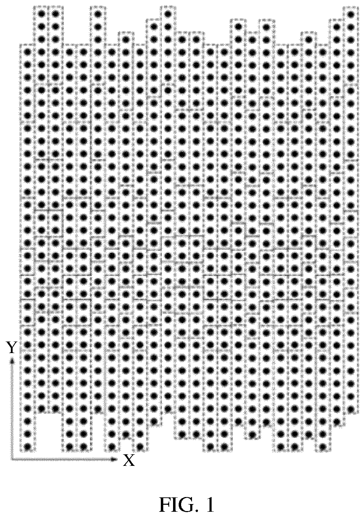

FIG. 1 shows an antenna array. Each black dot represents one radiating element. The antenna array includes 24 (along an X axis) × 32 (along a Y axis) radiating elements. Each column of the antenna array has eight subarrays along the Y axis, including a 2-element subarray, a 4-element subarray, a 6-element subarray, and an 8-element subarray. The 2-element subarray indicates that one phase shifter controls two radiating elements, the 4-element subarray indicates that one phase shifter controls four radiating elements, the 6-element subarray indicates that one phase shifter controls six radiating elements, and the 8-element subarray indicates that one phase shifter controls eight radiating elements.

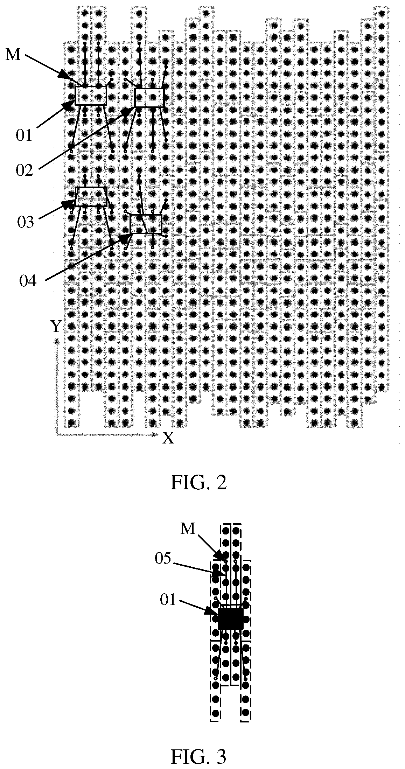

FIG. 2 is a schematic diagram of a connection between a subarray in the antenna array in FIG. 1 and a radio frequency integrated circuit (Radio Frequency Integrated Circuit, RFIC) chip. For example, FIG. 2 shows a first RFIC chip 01, a second RFIC chip 02, a third RFIC chip 03, and a fourth RFIC chip 04. The RFIC chips are connected to corresponding subarrays. Each subarray has a feed point M connected to the RFIC chip. It should be noted that the antenna array shown in FIG. 1 may be further connected to more radio frequency integrated circuit chips, and a quantity of chips and positions of the chips in FIG. 2 are merely examples.

The first RFIC chip is used as an example. In FIG. 3, the first RFIC chip 01 has eight radio frequency transmitting and receiving channels, and the eight radio frequency transmitting and receiving channels are connected to the eight subarrays in a one-to-one manner through feeder cables. For example, as shown in FIG. 3, a radio frequency transmitting and receiving channel in the first RFIC chip is connected to a feed point M of a subarray in the antenna array through a feeder cable 05. A connection relationship between the second RFIC chip 02, the third RFIC chip 03, and the fourth RFIC chip 04 and feed points of corresponding subarrays is similar to that shown in FIG. 3.

It can be learned from FIG. 3 that lengths of feeder cables for connecting the RFIC chip to feed points of a plurality of subarrays are inconsistent. Some feeder cables are long and some feeder cables are short. Because lengths of feeder cables connected to a same RFIC chip are different, signal transmission delays are also different. Consequently, phases of signals of the plurality of subarrays are different, an antenna array beamforming effect cannot be achieved, and broadband performance of the antenna array deteriorates. An existing phase calibration compensation can ensure only a narrowband calibration effect, and a beamforming effect is poor in a broadband case. In addition, as shown in FIG. 2, the RFIC chips are arranged at irregular positions, and therefore lengths of power divider lines for connecting power divider/combiners to the RFIC chips are different. This makes it difficult to design the power divider lines, and further deteriorates broadband performance of the antenna array. Further, because the plurality of RFIC chips shown in FIG. 2 are irregularly arranged, heat dissipated by the RFIC chips in an antenna module in which the antenna array is disposed is unevenly distributed. In this case, temperatures at different positions of the antenna module are different, thermal expansion amounts of feeder cables at different positions are also different, and the different thermal expansion amounts of the feeder cables also affect a phase of a signal of a subarray.

### SUMMARY

Embodiments of this application provide an antenna array, an apparatus, and a wireless communication device, to improve broadband performance of the antenna array by making feeder cables between an RFIC chip and feed points of subarrays in the antenna array basically equal in length.

To achieve the foregoing objective, the following technical solutions are used in embodiments of this application.

According to a first aspect, this application provides an antenna array. The antenna array includes:
a plurality of subarrays, where a feed point and at least one radiating element are disposed on each subarray, the plurality of subarrays are arranged in a first direction and a second direction, the first direction is perpendicular to the second direction, the feed points of the plurality of subarrays are located on a same straight line in the first direction, and the feed points of the plurality of subarrays are located on a same straight line in the second direction; and in the first direction, subarrays to which feed points on a same straight line belong are located in a same row, and in the second direction, subarrays to which feed points on a same straight line belong are located in a same column.

Each subarray has a phase center, phase centers of subarrays in at least one row of subarrays in the antenna array are not on a same straight line, and/or phase centers of subarrays in at least one column of subarrays in the antenna array are not on a same straight line.

According to the antenna array provided in this embodiment of this application, feed points of any row of subarrays are located on a same straight line, and feed points of any column of subarrays are located on a same straight line, so that the feed points of the antenna array are regularly arranged. When a radio frequency integrated circuit chip having at least two radio frequency transmitting and receiving channels is connected to feed points of at least two subarrays in a one-to-one manner through at least two feeder cables, lengths of every two feeder cables are basically equal. This avoids different phases of a plurality of subarrays caused by different lengths of a plurality of feeder cables connected to a same radio frequency integrated circuit chip.

In addition, a plurality of phase centers in at least one row are not located on a same straight line, and/or a plurality of phase centers in at least one column are not located on a same straight line. In other words, phase centers of the antenna array are irregularly arranged. In this way, the irregular arrangement of the phase centers may cause energy of grating lobes of the antenna array to be dispersed to a plurality of angles. This can effectively enhance grating lobe suppression and increase a gain of the antenna array.

Therefore, the antenna array provided in this embodiment of this application can further implement equal-length interconnection between the RFIC chip and the subarray while effectively elevating the grating lobe suppression and improving the gain of the antenna array.

In a possible implementation of the first aspect, the antenna array includes N subarrays, a same quantity of radiating elements are disposed on each of the N subarrays, a feed point of at least one of the N subarrays is different from a feed point of another subarray of the N subarrays, and N is an integer greater than or equal to 2. By setting different feed points of subarrays whose quantities of radiating elements are the same, regular arrangement of the feed points can be implemented.

In a possible implementation of the first aspect, the antenna array includes at least two types of same-type subarrays, and a same quantity of radiating elements are disposed in subarrays of one type of the same-type subarrays. In other words, the antenna array may include a subarray having two radiating elements, or may include a subarray having three radiating elements, or may include a subarray having more radiating elements.

In a possible implementation of the first aspect, the antenna array includes at least one first subarray, at least two radiating elements are arranged on the first subarray, and the at least two radiating elements are arranged in a straight line. A feed point of the first subarray is located between two adjacent radiating elements; or a feed point of the first subarray is located on a side that is of a radiating element located at an end of the first subarray and that is away from a remaining radiating element. In other words, when there are at least two radiating elements of the subarray, there are a plurality of cases of feed points. During specific implementation, selection may be performed based on a layout of feed points of the entire antenna array.

In a possible implementation of the first aspect, the antenna array includes at least one second subarray, a radiating element is arranged on the second subarray, and a feed point of the second subarray is located beside the radiating element.

In a possible implementation of the first aspect, in the first direction, spacings between feed points of every two adjacent subarrays are equal, and/or in the second direction, spacings between feed points of every two adjacent subarrays are equal. In this way, it is convenient to arrange the feed point.

In a possible implementation of the first aspect, the antenna array includes a dummy element, and the dummy element is a non-feed radiating element. To make the feed points of the antenna arrays be regularly arranged, in some cases, a grid without radiating element disposed needs to be formed between two adjacent subarrays. By disposing the dummy element in the grid, patterns of the subarrays can keep consistent. This improves a communication capacity of a wireless communication device.

In a possible implementation of the first aspect, the radiating element is a microstrip patch antenna, a symmetric oscillator, an open waveguide antenna, a helical antenna, or the like.

In a possible implementation of the first aspect, the radiating element may be dual-polarized, or may be single-polarized.

In a possible implementation of the first aspect, a polarization mode may be ±45° polarization, vertical or horizontal polarization, or right hand or left hand circular polarization.

In a possible implementation of the first aspect, the feeder cable of the subarray is a T-type power divider line, a Wilkinson power divider line, or a series-feed power divider line.

According to a second aspect, this application provides an apparatus. The apparatus includes:
the antenna array according to any one of the first aspect or the implementations of the first aspect;
a feeder cable; and
a circuit bearing board, where the feeder cable is configured to feed a subarray in the antenna array, and the antenna array and the feeder cable are disposed on the circuit bearing board.

The apparatus provided in this embodiment of this application includes the antenna array in any implementation of the first aspect. Because the feed points of the antenna array are regularly arranged, when a radio frequency integrated circuit chip having a plurality of radio frequency transmitting and receiving channels is connected to feed points of a plurality of subarrays in a one-to-one manner through a plurality of feeder cables, lengths of every two feeder cables are basically equal. This avoids different phases of the plurality of subarrays caused by different lengths of the plurality of feeder cables connected to a same radio frequency integrated circuit chip.

In addition, because phase centers of the subarrays in the antenna array are irregularly arranged, the irregular arrangement of the phase centers causes energy of grating lobes of the antenna array to be dispersed to a plurality of angles. This can effectively enhance grating lobe suppression, reduce interference to an external system, and improve an antenna gain to some extent.

In a possible implementation of the second aspect, the apparatus further includes at least one radio frequency integrated circuit chip. The radio frequency integrated circuit chip is disposed on the circuit bearing board. The radio frequency integrated circuit chip includes at least two radio frequency transmitting and receiving channels, the at least two radio frequency transmitting and receiving channels are configured to respectively feed at least two subarrays in the antenna array through the feeder cables, and the radio frequency transmitting and receiving channels are connected to the subarrays in a one-to-one manner.

In a possible implementation of the second aspect, an antenna module includes a power divider/combiner and at least two radio frequency integrated circuit chips. The power divider/combiner is separately connected to the at least two radio frequency integrated circuit chips through at least two power divider lines, the at least two power divider lines have a same length, and the power divider lines are connected to the radio frequency integrated circuit chips in a one-to-one manner. A design of an equal length of the power divider lines between the power divider/combiner and the RFIC chip further reduces differences between delays from the power divider/combiner to different subarrays. This further improves broadband performance.

In a possible implementation of the second aspect, the circuit bearing board is a package substrate. The antenna module further includes a printed circuit board. The package substrate is disposed on the printed circuit board and is connected to the printed circuit board, and the power divider/combiner is disposed on the printed circuit board. Generally, a digital-to-analog conversion module and a digital signal processing module are further disposed on the printed circuit board. The digital signal processing module is connected to the digital-to-analog conversion module, and the digital-to-analog conversion module is connected to the power divider/combiner. The antenna array is disposed on the package substrate, and the radio frequency integrated circuit chip is also disposed on the package substrate. Then the antenna array, the package substrate, and the radio frequency integrated circuit chip are packaged as a whole and connected to the printed circuit board, to form an antenna in package (Antenna-In-Package, AIP).

In a possible implementation of the second aspect, the circuit bearing board is a printed circuit board; and the power divider/combiner is disposed on the printed circuit board. Generally, a digital-to-analog conversion module and a digital signal processing module are further disposed on the printed circuit board. The digital signal processing module is connected to the digital-to-analog conversion module, and the digital-to-analog conversion module is connected to the power divider/combiner. The antenna array, the radio frequency integrated circuit chip, the digital-to-analog conversion module, and the digital signal processing module are all disposed on the printed circuit board, to form an antenna on board (Antenna-on-Board, AOB).

In a possible implementation of the second aspect, the apparatus further includes a heat sink, and the heat sink can dissipate heat for the radio frequency integrated circuit chip. Heat dissipation is performed on the radio frequency integrated circuit chip by using the heat sink, to improve performance of the radio frequency integrated circuit chip.

According to a third aspect, this application provides an apparatus. The apparatus includes:
the antenna array according to the first aspect;
a feeder cable; and
at least one radio frequency integrated circuit chip, where the antenna array and the feeder cable are disposed on a packaging layer of the radio frequency integrated circuit chip, the radio frequency integrated circuit chip includes at least two radio frequency transmitting and receiving channels, the at least two radio frequency transmitting and receiving channels are configured to respectively feed at least two subarrays in the antenna array through the feeder cables, and the radio frequency transmitting and receiving channels are connected to the subarrays in a one-to-one manner.

In the apparatus provided in this embodiment of this application, the feeder cable and the antenna array are disposed on the radio frequency integrated circuit chip, and the antenna array is the antenna array in any implementation of the first aspect. Therefore, the antenna module provided in this embodiment of this application and the antenna array in the foregoing technical solution can resolve a same technical problem, and achieve a same expected effect.

In a possible implementation of the third aspect, the apparatus includes a power divider/combiner and at least two radio frequency integrated circuit chips. The power divider/combiner is separately connected to the at least two radio frequency integrated circuit chips through at least two power divider lines, the at least two power divider lines have a same length, and the power divider lines are connected to the radio frequency integrated circuit chips in a one-to-one manner. A design of an equal length of the power divider lines between the power divider/combiner and the radio frequency integrated circuit chips further reduces differences between delays from the power divider/combiner to different subarrays. This further improves broadband performance.

In a possible implementation of the third aspect, the apparatus further includes a printed circuit board, and both the radio frequency integrated circuit chip and the power divider/combiner are disposed on the printed circuit board. Generally, a digital-to-analog conversion module and a digital signal processing module are further disposed on the printed circuit board. The digital signal processing module is connected to the digital-to-analog conversion module, and the digital-to-analog conversion module is connected to the power divider/combiner. In other words, the antenna array is directly disposed on the radio frequency integrated circuit chip and is connected to the printed circuit board, to form an antenna-on-chip (Antenna-On-Chip, AOC).

According to a fourth aspect, this application further provides a wireless communication device, including the antenna array in any implementation of the first aspect, or the apparatus in any implementation of the second aspect or the third aspect.

The wireless communication device provided in this embodiment of this application includes the antenna array provided in the foregoing embodiment. Therefore, the wireless communication device provided in this embodiment of this application and the antenna array in the foregoing technical solution can resolve a same technical problem, and achieve a same expected effect.

### BRIEF DESCRIPTION OF DRAWINGS

FIG. 1 is a schematic diagram of a structure of an antenna array in a current technology;
FIG. 2 is a schematic diagram of a connection between a subarray in the antenna array in FIG. 1 and an RFIC chip;
FIG. 3 is a schematic diagram of a connection relationship between a first RFIC chip in FIG. 2 and a feed point;
FIG. 4 is a schematic diagram of a structure of an antenna module according to an embodiment of this application;
FIG. 5 is a schematic diagram of a structure of an antenna module according to an embodiment of this application;
FIG. 6 is a schematic diagram of a structure of an antenna module according to an embodiment of this application;
FIG. 7 is a schematic diagram of a structure of an antenna array according to an embodiment of this application;
FIG. 8 is an arrangement diagram of feed points of the antenna array in FIG. 7;
FIG. 9 is a schematic diagram of a connection relationship between some feed points of the antenna array in FIG. 8 and an RFIC chip;
FIG. 10 is a schematic diagram of a connection relationship between one RFIC chip and feed points;
FIG. 11 is a schematic diagram of a connection relationship between a plurality of RFIC chips and a power divider/combiner;
FIG. 12 is an arrangement diagram of phase centers of the antenna array in FIG. 7;
FIG. 13 is a schematic diagram of a structure of an antenna array according to an embodiment of this application;
FIG. 14 is an arrangement diagram of feed points of the antenna array in FIG. 13;
FIG. 15 is a schematic diagram of a connection relationship between some feed points of the antenna array in FIG. 14 and an RFIC chip;
FIG. 16 is a schematic diagram of a connection relationship between one RFIC chip and feed points;
FIG. 17 is a schematic diagram of a connection relationship between a plurality of RFIC chips and a power divider/combiner;
FIG. 18 is an arrangement diagram of phase centers of the antenna array in FIG. 13;
FIG. 19 is a comparison diagram of curves of grating lobe suppression of an antenna array and an existing antenna array according to an embodiment of this application;
FIG. 20 is a comparison diagram of curves of vertical scanning envelope gains of an antenna array and an existing antenna array according to an embodiment of this application;
FIG. 21 is a schematic diagram of a layout of some subarrays of an antenna array according to an embodiment of this application;
FIG. 22 is a schematic diagram of a layout of a feed point of a subarray including one radiating element in an antenna array according to an embodiment of this application;
FIG. 23a is a schematic diagram of a layout of a feed point of a subarray including two radiating elements in an antenna array according to an embodiment of this application;
FIG. 23b is a schematic diagram of a layout of a feed point of a subarray including two radiating elements in an antenna array according to an embodiment of this application;
FIG. 23c is a schematic diagram of a layout of a feed point of a subarray including two radiating elements in an antenna array according to an embodiment of this application;
FIG. 24a is a schematic diagram of a layout of a feed point of a subarray including three radiating elements in an antenna array according to an embodiment of this application;
FIG. 24b is a schematic diagram of a layout of a feed point of a subarray including three radiating elements in an antenna array according to an embodiment of this application;
FIG. 24c is a schematic diagram of a layout of a feed point of a subarray including three radiating elements in an antenna array according to an embodiment of this application;
FIG. 24d is a schematic diagram of a layout of a feed point of a subarray including three radiating elements in an antenna array according to an embodiment of this application;
FIG. 25 is a schematic diagram of a structure of an antenna array according to an embodiment of this application; and
FIG. 26 is a schematic diagram of a structure of an antenna array according to an embodiment of this application.

### Reference numerals:

01: First RFIC chip; 02: Second RFIC chip; 03: Third RFIC chip; 04: Fourth RFIC chip; 05: Feeder cable; 1: Antenna array; 1A and 1B: Subarray; 11: Radiating element; 111: First radiating element; 112: Second radiating element; 113: Third radiating element; M: Feed point; N: Phase center; 2: Dummy element; 3: RFIC chip; 31: First RFIC chip; 32: Second RFIC chip; 33: Third RFIC chip; 34: Fourth RFIC chip; 35: Fifth RFIC chip; 36: Sixth RFIC chip; 37: Seventh RFIC chip; 38: Eighth RFIC chip; 4: Circuit bearing board; 5: Power divider/combiner; 6: Printed circuit board; 7: Channel; 8: Heat sink; 9: Power divider line; 10: Connection structure.

### DESCRIPTION OF EMBODIMENTS

In a wireless communication device, such as a wireless base station, with higher data communication rates, millimeter-wave bands have been included in 5th generation mobile communication (5th generation mobile communication, 5G). In this way, while meeting a protocol requirement for coexistence of a 5G high-frequency base station and a satellite, higher requirements are imposed on antenna array performance. For example, grating lobe (Grating lobes) suppression of an antenna array needs to be further enhanced, and a scanning pattern gain envelope of the antenna array needs to be better.

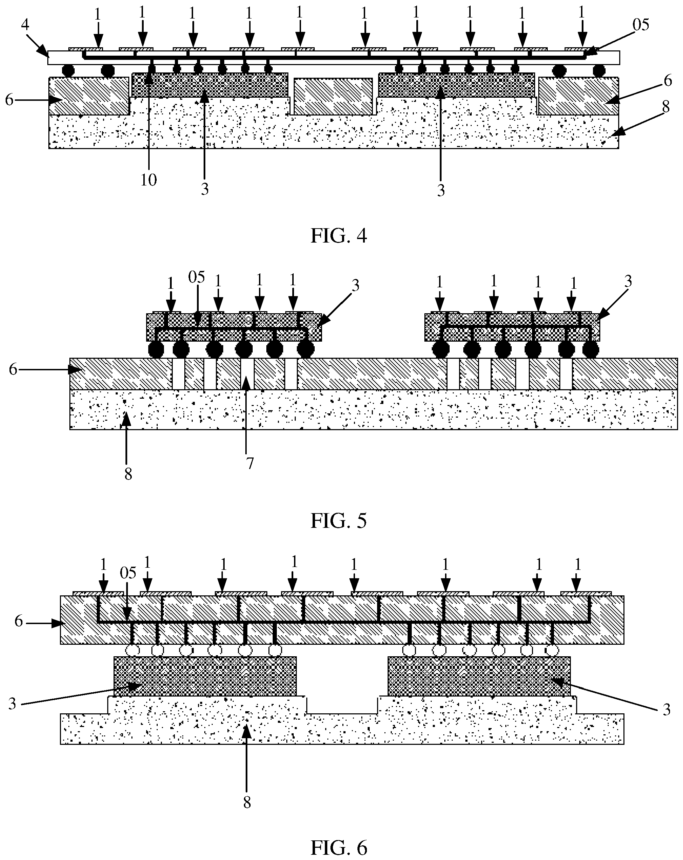

In the wireless communication device, the antenna array has a plurality of different bearer manners. For example, FIG. 4, FIG. 5, and FIG. 6 show three different bearer manners.

With reference to FIG. 4, an antenna array 1 is disposed on a circuit bearing board 4, and a feeder cable 05 is also disposed on the circuit bearing board 4. The feeder cable 05 may be a metal cable laid on the circuit bearing board. The circuit bearing board 4 in this structure is a package substrate (substrate). For example, the package substrate may be a redistribution layer (redistribution layer, RDL), or a coreless substrate (Coreless substrate) without a core layer.

An RFIC chip 3 is connected, by using a connection structure 10, to the package substrate on which the antenna array 1 and the feeder cable 05 are disposed. Then, the package substrate on which the RFIC chip 3 is disposed is connected to a printed circuit board (printed circuit board, PCB) 6 by using the connection structure 10. Such a structure may be referred to as an antenna-in-package (Antenna-In-Package, AIP).

With reference to FIG. 5, both an antenna array 1 and a feeder cable 05 are disposed on an RFIC chip 3, and the RFIC chip 3 on which the antenna array 1 and the feeder cable 05 are disposed is disposed on a PCB 6 by using a connection structure, and is connected to the PCB 6. Such a structure may be referred to as an antenna-on-chip (Antenna-On-Chip, AOC).

With reference to FIG. 6, an antenna array 1 is disposed on a circuit bearing board, and a feeder cable 05 is also disposed on the circuit bearing board. The circuit bearing board in this structure is a PCB 6. The RFIC chip 3 is connected to the PCB 6 by using a connection structure. Such a structure may be referred to as an antenna-on-board (Antenna-on-Board, AOB).

The connection structure 10 may be a ball grid array (ball grid array, BGA). Certainly, another connection structure may also be selected.

The AIP, the AOC, or the AOB further includes a heat sink 8. In the AIP, the heat sink 8 is disposed close to the PCB 6 and the RFIC chip 3, to dissipate heat emitted by the PCB 6 and the RFIC chip 3. In the AOC, the heat sink 8 is disposed close to the PCB 6, and a channel 7 passes through the PCB 6. In this way, heat dissipation can also be performed on the RFIC chip 3. In the AOB, the heat sink 8 is disposed close to the RFIC chip 3. A structure and a layout manner of the heat sink are not specially limited in this application.

In the AIP, the AOC, or the AOB, a digital-to-analog conversion module, a digital signal processing module, and a power divider/combiner are disposed on the PCB 6. The digital signal processing module is connected to the digital-to-analog conversion module, the digital-to-analog conversion module is connected to the power divider/combiner, and the power divider/combiner is connected to the RFIC chip through a power divider line. The power divider line may also be a metal cable. In an optional implementation, the metal cable on the PCB 6 may be used to connect the digital signal processing module and the digital-to-analog conversion module, and connect the digital-to-analog conversion module and the power divider/combiner.

The antenna array may be applied to an analog active phased array, or may be applied to a digital active phased array.

Only three apparatuses for bearing the antenna array are provided above. In addition, the antenna array may alternatively be disposed in another apparatus. The apparatus is not specially limited in this application.

The antenna array in this application includes a plurality of subarrays (Subarray), each subarray includes at least one radiating element, and the plurality of subarrays are arranged in a first direction and a second direction. The first direction is perpendicular to the second direction. In other words, the plurality of subarrays are arranged horizontally and vertically to form the antenna array.

In the foregoing three structures, a power divider/combiner is connected to at least two RFIC chips 3 through at least two power divider lines. In addition, one RFIC chip 3 includes at least two radio frequency transmitting and receiving channels, to be specific, one RFIC chip 3 has at least two radio frequency transmitting and receiving ports. In other words, the RFIC chip 3 having at least two radio frequency transmitting and receiving channels feeds at least two subarrays in a one-to-one manner through at least two feeder cables, so that the subarrays receive and transmit signals.

It may also be understood as that transmission paths between the power divider/combiner and the subarray include not only a power divider line path, but also a feed path. If transmission paths between one power divider/combiner and a plurality of subarrays are different, delays are different, and phases of the plurality of subarrays are different. In this way, broadband performance of the antenna array deteriorates.

To further reduce delay differences between different subarrays and further improve broadband performance, an embodiment of this application provides an antenna array. The antenna array may be applied to the AIP, the AOC, or the AOB, and certainly, may alternatively be applied to another apparatus including the antenna array.

The following describes the antenna array 1 in detail.

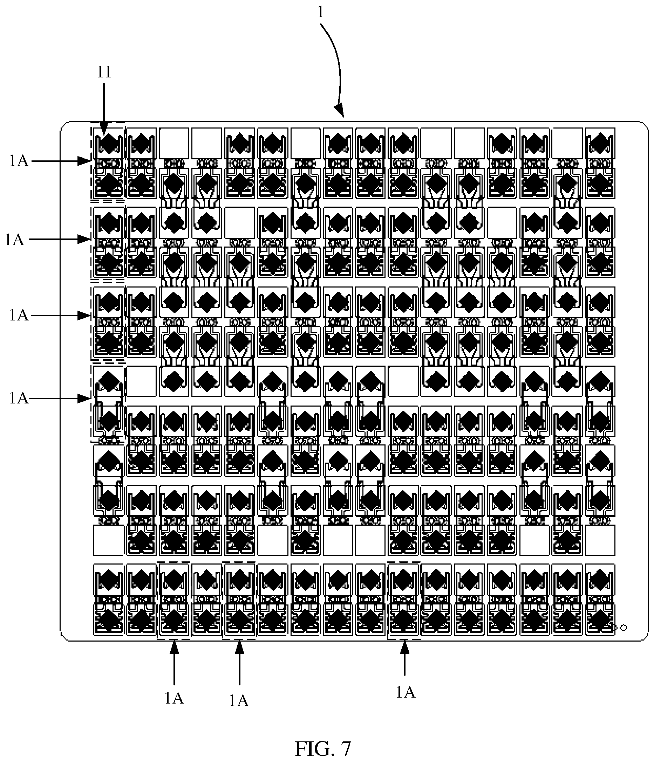

FIG. 7 is a structure diagram of the antenna array 1. Radiating elements 11 in the antenna array 1 form a plurality of subarrays (for example, 1A in FIG. 7 represents one subarray), and the plurality of subarrays form the antenna array.

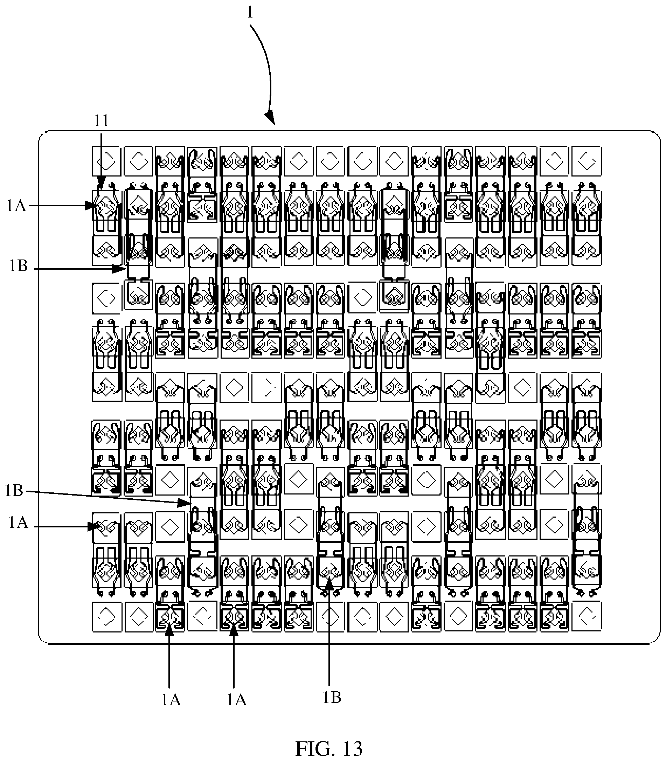

As shown in FIG. 7, the subarray 1A includes two radiating elements. A subarray including a same quantity of radiating elements may be a same-type subarray. Actually, there may be another quantity of radiating elements in the subarray. For example, a subarray 1B shown in FIG. 13 includes three radiating elements. A subarray including any quantity of radiating elements shall fall within the protection scope of this application.

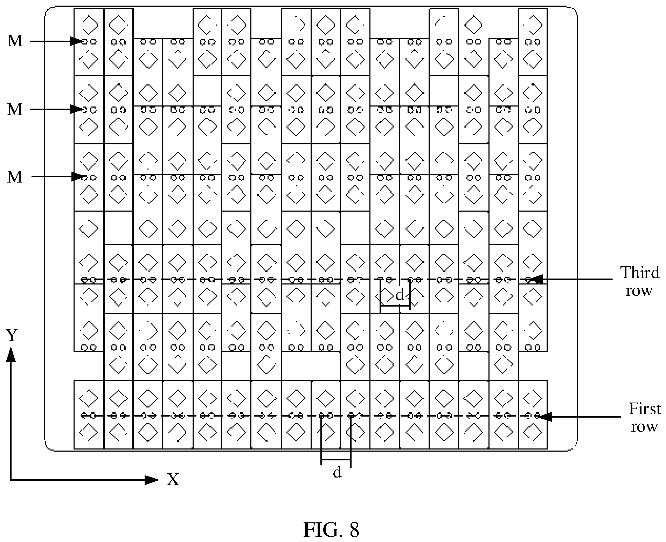

Each subarray has a feed point M. For example, when the antenna array includes at least three subarrays, there are at least three feed points M, as shown in FIG. 8.

It should be noted that a polarization mode of the radiating element is not limited in this application. FIG. 7 shows a dual-polarized antenna in ±45° polarization. The radiating element may alternatively be a single-polarized antenna, and the polarization mode may alternatively be horizontal or vertical polarization, or left hand or right hand circular polarization.

Arrangement of the feed points M in the antenna array provided in this embodiment of this application meets the following conditions.

Feed points M of the plurality of subarrays are located on at least one straight line in a first direction X, and feed points M of the plurality of subarrays are also located on at least one straight line in a second direction Y.

In the first direction X, the plurality of subarrays to which the plurality of feed points M located on a same straight line belong are located in a same row. In the second direction Y, the plurality of subarrays to which the plurality of feed points M located on a same straight line belong are located in a same column.

In this way, with reference to FIG. 8, a plurality of feed points of each row of subarrays are arranged along a straight line, and a plurality of feed points of each column of subarrays are also arranged along a straight line, so that the feed points of the antenna array are regularly arranged.

In addition, to further help layout the feed points, a spacing between two adjacent feed points in each row is equal. It can be learned from FIG. 8 that a spacing between every two adjacent feed points in the first row of subarrays is d, and a spacing between every two adjacent feed points in the third row of subarrays is also d. Alternatively, a spacing between every two adjacent feed points in each column is equal. Alternatively, a spacing between every two adjacent feed points in any column is equal, and a spacing between every two adjacent feed points in any row is equal.

When the feed points of the antenna array are regularly arranged, and an RFIC chip having at least two radio frequency transmitting and receiving channels is connected to at least two feed points in a one-to-one manner through at least two feeder cables, a plurality of feeder cables connected to a same RFIC chip may be basically equal in length, that is, feed paths are the same. Therefore, delay differences between the plurality of subarrays connected to the same RFIC chip are reduced, so that phases of the plurality of subarrays are basically the same.

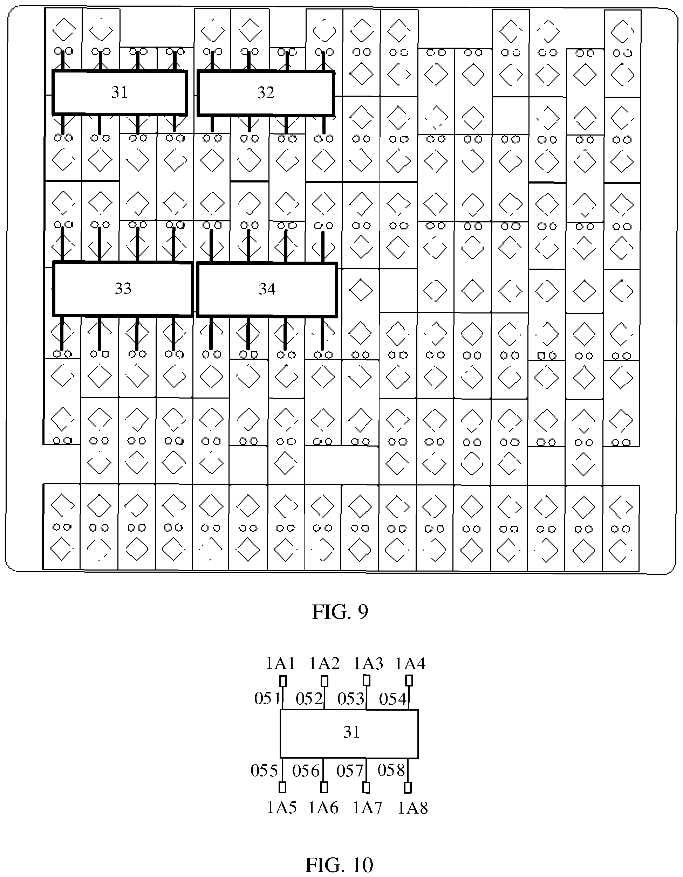

For example, as shown in FIG. 9 and FIG. 10, a first RFIC chip 31 is an RFIC chip having eight radio frequency transmitting and receiving channels. The first RFIC chip 31 is connected to a subarray 1A1, a subarray 1A2, a subarray 1A3, a subarray 1A4, a subarray 1A5, a subarray 1A6, a subarray 1A7, and a subarray 1A8. To be specific, a first radio frequency transmitting and receiving channel of the first RFIC chip 31 is interconnected with the subarray 1A1 through a feeder cable 051. A second radio frequency transmitting and receiving channel of the first RFIC chip 31 is interconnected with the subarray 1A2 through a feeder cable 052. A third radio frequency transmitting and receiving channel of the first RFIC chip 31 is interconnected with the subarray 1A3 through a feeder cable 053. A fourth radio frequency transmitting and receiving channel of the first RFIC chip 31 is interconnected with the subarray 1A4 through a feeder cable 054. A fifth radio frequency transmitting and receiving channel of the first RFIC chip 31 is interconnected with the subarray 1A5 through a feeder cable 055. A sixth radio frequency transmitting and receiving channel of the first RFIC chip 31 is interconnected with the subarray 1A6 through a feeder cable 056. A seventh radio frequency transmitting and receiving channel of the first RFIC chip 31 is interconnected with the subarray 1A7 through a feeder cable 057. An eighth radio frequency transmitting and receiving channel of the first RFIC chip 31 is interconnected with the subarray 1A8 through a feeder cable 058.

It should be noted that, in this application, only the RFIC chip having eight radio frequency transmitting and receiving channels is used as an embodiment. Alternatively, an RFIC chip having another quantity of radio frequency transmitting and receiving channels may be used.

It can be learned from FIG. 10 that lengths of the feeder cable 051, the feeder cable 052, the feeder cable 053, the feeder cable 054, the feeder cable 055, the feeder cable 056, the feeder cable 057, and the feeder cable 058 are basically equal. When the lengths of the feeder cables are equal, phases of the subarray 1A1, the subarray 1A2, the subarray 1A3, the subarray 1A4, the subarray 1A5, the subarray 1A6, the subarray 1A7, and the subarray 1A8 may be the same, to improve broadband performance of the antenna array.

When the feed points of the antenna array are regularly arranged, arrangement of a plurality of RFIC chips in the apparatus is also regular, and lengths of at least two power divider lines between one power divider/combiner and at least two RFIC chips are basically equal. This simplifies design difficulty of the power divider lines. Especially, power divider line paths between one power divider/combiner and the at least two RFIC chips are basically the same. In this way, delay differences between subarrays are further reduced, and broadband performance is further improved.

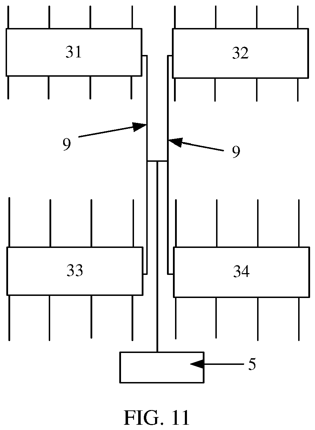

For example, as shown in FIG. 11, a first RFIC chip 31, a second RFIC chip 32, a third RFIC chip 33, and a fourth RFIC chip 34 are all RFIC chips having eight radio frequency transmitting and receiving channels. A power divider/combiner 5 is separately connected to the first RFIC chip 31, the second RFIC chip 32, the third RFIC chip 33, and the fourth RFIC chip 34 through power divider lines 9.

It can be learned from FIG. 11 that, the first RFIC chip 31, the second RFIC chip 32, the third RFIC chip 33, and the fourth RFIC chip 34 are regularly arranged, and the power divider lines 9 are basically equal in length.

When the feed points of the antenna array are regularly arranged, it can be learned from FIG. 9 that the first RFIC chip 31, the second RFIC chip 32, the third RFIC chip 33, and the fourth RFIC chip 34 are regularly arranged, and heat dissipation of these RFIC chips is also evenly distributed. This avoids a high local temperature or a low local temperature of the RFIC chips, and avoids impact on performance of an entire wireless communication device.

It should be noted that, the foregoing technical effect analysis is performed by using only some RFIC chips and some subarrays, and technical effects generated by other RFIC chips and other subarrays are the same as the foregoing technical effects.

Based on the foregoing descriptions, at least two power divider lines between one power divider/combiner 5 and the at least two RFIC chips 3 are basically equal in length, and feeder cables between one RFIC chip 3 and the at least two subarrays are basically equal in length. In this way, transmission paths between one power divider/combiner 5 and the at least two subarrays are basically equal in length. Therefore, in comparison with a current technology, delay differences between different sub arrays are evidently reduced, and phases of the different subarrays are basically the same. This improves broadband performance of the antenna array.

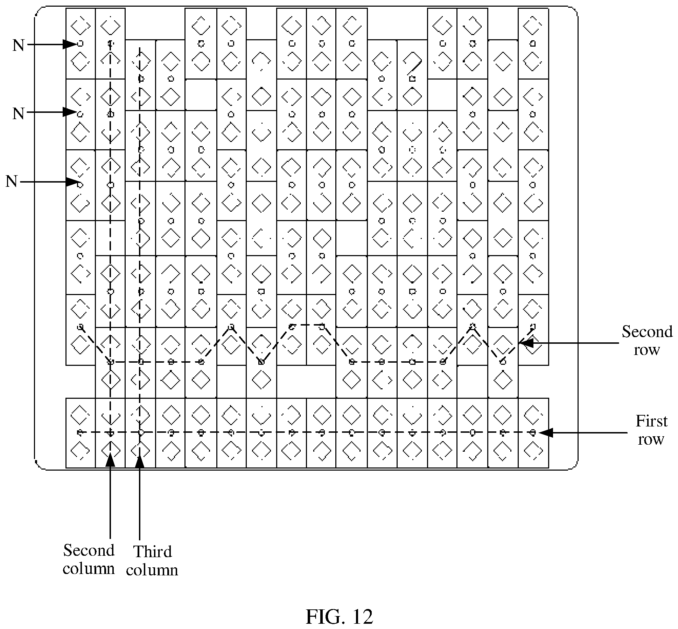

As shown in FIG. 12, each subarray has a phase center (Phase Center) N. For example, when the antenna array includes at least three subarrays, there are at least three phase centers N.

It should be noted that, after an electromagnetic wave radiated by the subarray leaves the subarray for a specific distance, a constant phase plane of the electromagnetic wave is approximately a sphere, and a sphere center of the sphere is a phase center of the subarray, or an area around the sphere center is considered as a phase center of the subarray. In practice, for a planar subarray, it may be usually considered that a phase center of the planar subarray coincides with a geometric center of the planar subarray, and the geometric center is a geometric center of a phase plane that is approximately a sphere and that is of an electromagnetic wave radiated by the subarray.

Arrangement of phase centers N in the antenna array provided in this embodiment of this application meets the following conditions.
1. A plurality of phase centers in at least one row are not located on a same straight line.
   In the antenna array shown in FIG. 12, a plurality of phase centers in the first row are arranged in a straight line, but a plurality of phase centers in the second row are arranged in a bending line. In other words, a stagger phenomenon occurs in the phase centers in the second row.
2. A plurality of phase centers in at least one column are not located on a same straight line.
3. A plurality of phase centers in at least one row are not located on a same straight line, and a plurality of phase centers in at least one column are not located on a same straight line.

When the phase centers of the antenna array meet any one of the foregoing conditions, it is considered that the phase centers of the antenna array are irregularly arranged.

Irregular arrangement of the phase centers may cause a case that during scanning of the antenna array, energy of grating lobes (Grating lobes) is no longer superimposed at a few angles, but is dispersed at a plurality angles. Therefore, a grating lobe suppression capability of the antenna array can be greatly improved.

FIG. 13 is a structure diagram of another antenna array. The antenna array includes a subarray 1A having two radiating elements 11, and further includes a subarray 1B having three radiating elements 11.

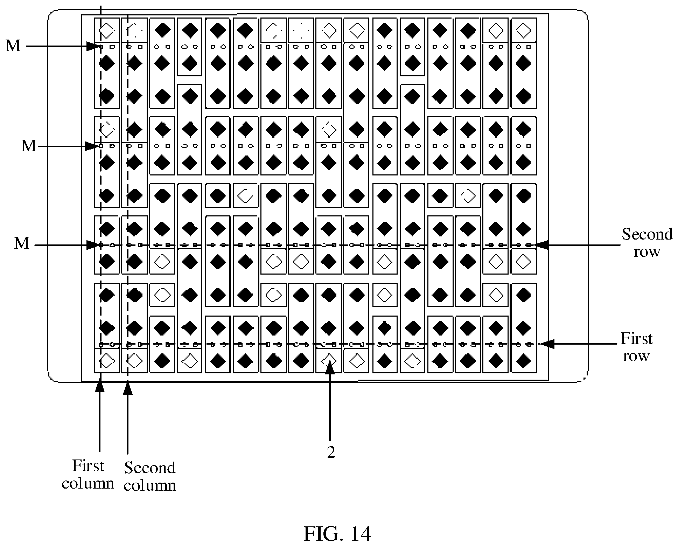

With reference to FIG. 14, feed points M in the antenna array also meet the following condition: Feed points of a plurality of subarrays in each row of subarrays are arranged in a straight line, and feed points of a plurality of subarrays in each column of subarrays are also arranged in a straight line. In this way, the feed points of the antenna array are regularly arranged. For example, feed points of a plurality of subarrays in the first row and feed points of a plurality of subarrays in the second row adjacent to the first row are arranged in a straight line. Feed points of a plurality of subarrays in the first column and feed points of a plurality of subarrays in the second column adjacent to the first column are also arranged in a straight line.

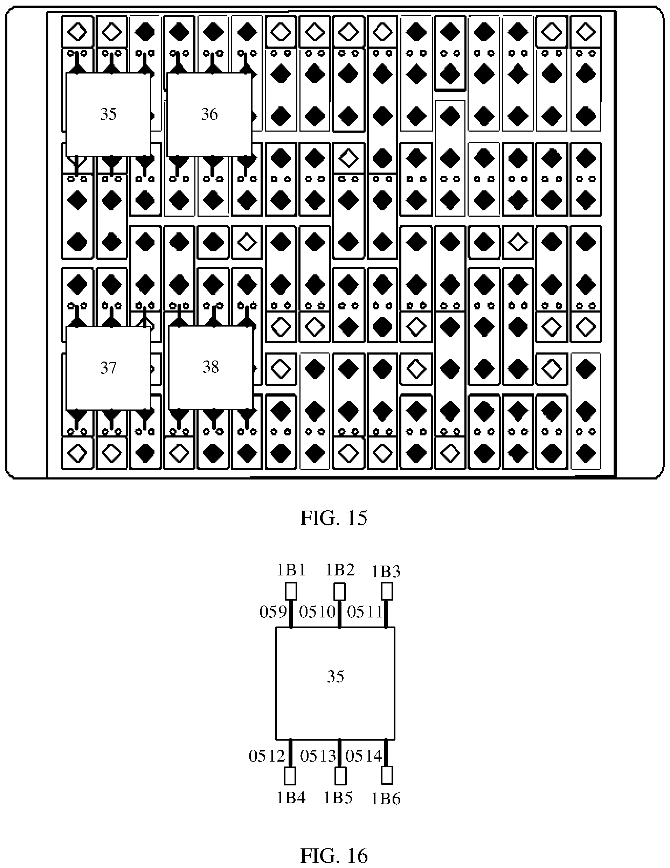

As shown in FIG. 15 and FIG. 16, a fifth RFIC chip 35 is an RFIC chip having six radio frequency transmitting and receiving channels. The fifth RFIC chip 35 is connected to a subarray 1B1, a subarray 1B2, a subarray 1B3, a subarray 1B4, a subarray 1B5, and a subarray 1B6. To be specific, a first radio frequency transmitting and receiving channel of the fifth RFIC chip 35 is interconnected with the subarray 1B1 through a feeder cable 059. A second radio frequency transmitting and receiving channel of the fifth RFIC chip 35 is interconnected with the subarray 1B2 through a feeder cable 0510. A third radio frequency transmitting and receiving channel of the fifth RFIC chip 35 is interconnected with the subarray 1B3 through a feeder cable 0511. A fourth radio frequency transmitting and receiving channel of the fifth RFIC chip 35 is interconnected with the subarray 1B4 through a feeder cable 0512. A fifth radio frequency transmitting and receiving channel of the fifth RFIC chip 35 is interconnected with the subarray 1B5 through a feeder cable 0513. A sixth radio frequency transmitting and receiving channel of the fifth RFIC chip 35 is interconnected with the subarray 1B6 through a feeder cable 0514.

It can be learned from FIG. 16 that lengths of the feeder cable 059 to the feeder cable 0514 are basically equal. When lengths of the feeder cables are equal, phases of the subarray 1B1, the subarray 1B2, the subarray 1B3, the subarray 1B4, the subarray 1B5, and the subarray 1B6 may be basically the same, to improve broadband performance of the antenna array.

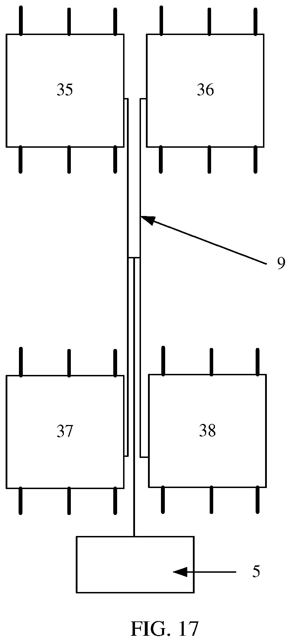

FIG. 17 shows a connection relationship between four RFIC chips and a power divider/combiner 5. The four RFIC chips are respectively a fifth RFIC chip 35, a sixth RFIC chip 36, a seventh RFIC chip 37, and an eighth RFIC chip 38.

It can be learned from FIG. 17 that, the fifth RFIC chip 35, the sixth RFIC chip 36, the seventh RFIC chip 37, and the eighth RFIC chip 38 are regularly arranged, and power divider lines between the power divider/combiner and the four RFIC chips are basically equal in length.

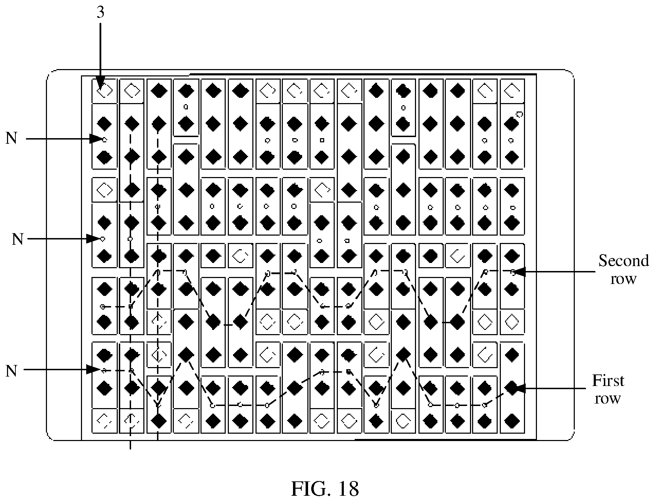

As shown in FIG. 18, phase centers N of the antenna array are irregularly arranged. For example, phase centers of a plurality of subarrays in the first row form a bending line, and phase centers of a plurality of subarrays in the second row also form a bending line. In this way, irregular arrangement of the phase centers may cause a case that energy of grating lobes is no longer superimposed at a few angles during scanning of the antenna array, but is dispersed at a plurality angles. Therefore, a grating lobe suppression capability of the antenna array can be greatly improved.

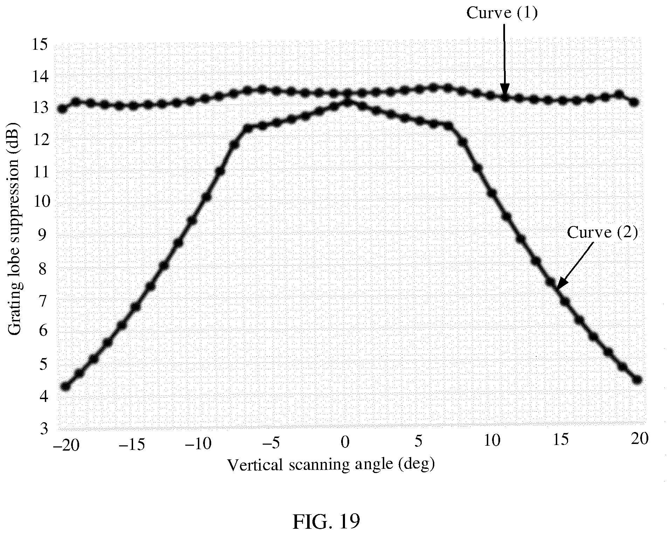

FIG. 19 is a comparison diagram of curves of grating lobe suppression of an antenna array and an existing antenna array according to this application. A curve (1) is a curve of grating lobe suppression obtained when the antenna array provided in this embodiment of this application is scanned along a Y axis (vertical dimension), and a curve (2) is a curve of grating lobe suppression obtained when the antenna array is scanned along the Y axis (vertical dimension) in a current technology. It can be evidently learned from the curve (1) and the curve (2) that, in a range of a vertical scanning angle from -20° to 20°, grating lobe suppression in this application is evidently higher than existing grating lobe suppression.

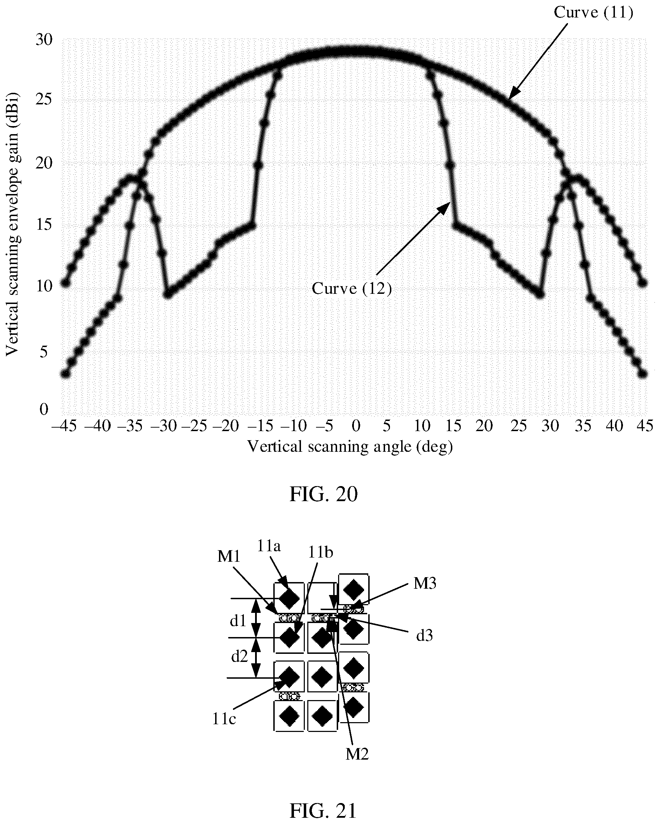

FIG. 20 is a comparison diagram of curves of vertical scanning envelope gains of an antenna array and an existing antenna array according to this application. In this figure, a curve (11) is an envelope gain curve of a beam scanning pattern of the antenna array provided in this application along a Y axis (vertical dimension), and a curve (12) is an envelope gain curve of a beam scanning pattern of the existing antenna array along the Y axis (vertical dimension). It can be learned that gains of the antenna array in this application are better than those of the existing antenna array in both a range of -30° to -10° and a range of 10° to 30°, while gains are basically equivalent in a range of -10° to 10°. In addition, a beam scanning capability is defined through 10 dB grating lobe suppression. Refer to FIG. 21. An existing antenna array scanning capability is in a range of -10° to 10°. In this application, a scanning capability is in a range greater than ±20°, and an actual capability may reach about ±30°. In FIG. 20, beam scanning in the Y direction is used as an example, and a similar technical effect also exists in an X direction.

In an optional implementation, radiating elements are not limited to being evenly distributed in grids. To be specific, as shown in FIG. 21, a radiating element 11a, a radiating element 11b, and a radiating element 11c are sequentially arranged in a same column. A spacing between adjacent radiating elements 11a and 11b is d1, and a spacing between adjacent radiating elements 11b and 11c is d2. Herein, d1 and d2 may be equal, alternatively, an absolute value of a difference between d1 and d2 may be less than or equal to 1/4 of a wavelength corresponding to a frequency band of the antenna array.

In an optional implementation, feed points of a plurality of subarrays in a first direction may allow a specific degree of stagger, and are not limited to being completely on a same straight line. Similarly, feed points of a plurality of subarrays in a second direction may allow a specific degree of stagger, and are not limited to being completely on a same straight line. As shown in FIG. 21, a feed point M1, a feed point M2, and a feed point M3 are arranged in the first direction, the feed point M2 and the feed point M3 are staggered, and a stagger distance d3 is less than or equal to 1/4 of a wavelength corresponding to a frequency band of the antenna array. When two adjacent feed points are staggered, and a stagger distance is less than or equal to 1/4 of the wavelength corresponding to the frequency band of the antenna array, impact on a design of an equal length of feeder cables and an equal split line is very small, and broadband performance of the antenna array can still be improved.

As described above, in the antenna array, the feed points are irregularly arranged. In other words, in same-type subarrays, there are a plurality of cases of feed points. The following describes, by using an embodiment, a specific manner of setting feed points to implement irregular arrangement.

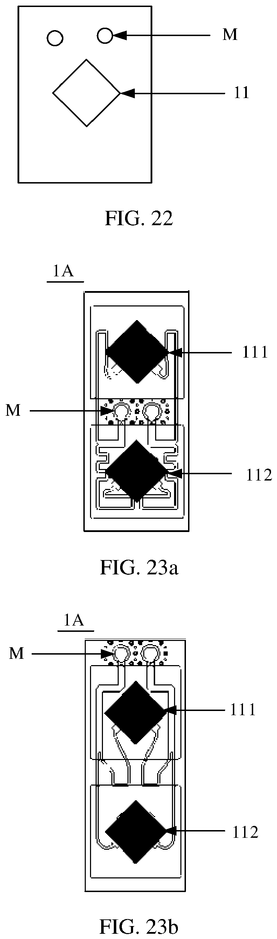

FIG. 22 shows a subarray including only one radiating element 11. In the subarray, a feed point M is located beside the radiating element 11.

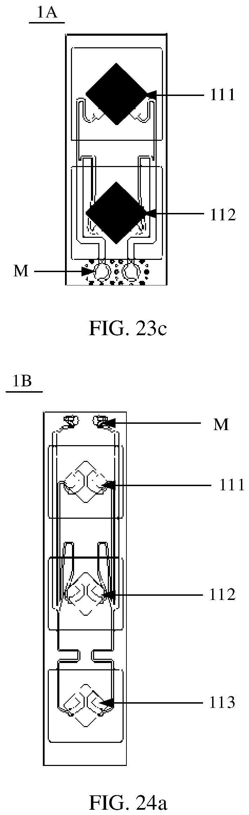

FIG. 23a, FIG. 23b, and FIG. 23c each show an arrangement manner of feed points in a subarray including two radiating elements. The two radiating elements are respectively a first radiating element 111 and a second radiating element 112.

First arrangement manner: Refer to FIG. 23a. The feed point M is located between the first radiating element 111 and the second radiating element 112.

Second arrangement position: Refer to FIG. 23b. The feed point M is located on a side that is of the first radiating element 111 and that is away from the second radiating element 112.

Third arrangement position: Refer to FIG. 23c. The feed point M is located on a side that is of the second radiating element 112 and that is away from the first radiating element 111.

In addition, the feed point M may alternatively be below the first radiating element 111 or below the second radiating element 112.

Certainly, when the antenna array includes a subarray having two radiating elements, the feed point includes the foregoing arrangement positions, but is not limited to these arrangement positions.

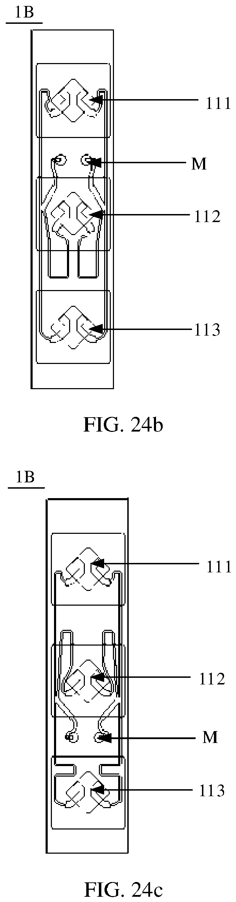

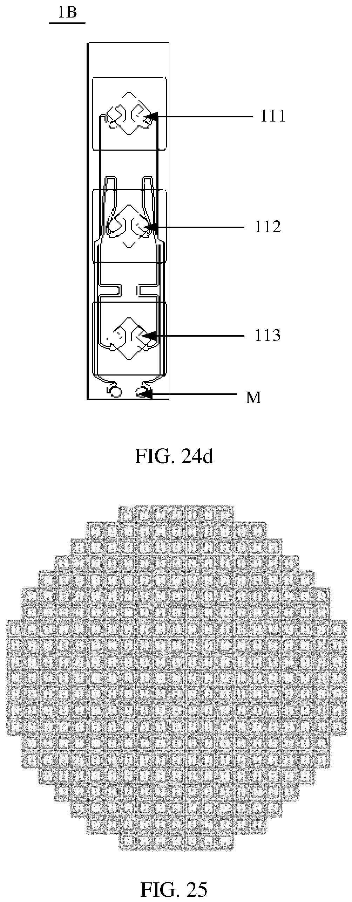

FIG. 24a, FIG. 24b, FIG. 24c, and FIG. 24d each show an arrangement manner of feed points in a subarray including three radiating elements. The three radiating elements are respectively a first radiating element 111, a second radiating element 112, and a third radiating element.

First arrangement position: Refer to FIG. 24a. The feed point M is located on a side that is of the first radiating element 111 and that is away from the second radiating element 112.

Second arrangement position: Refer to FIG. 24b. The feed point M is located between the first radiating element 111 and the second radiating element 112.

Third arrangement position: Refer to FIG. 24c. The feed point M is located between the second radiating element 112 and the third radiating element 113.

Fourth arrangement position: Refer to FIG. 24d. The feed point M is located on a side that is of the third radiating element 113 and that is away from the second radiating element 112.

In addition, the feed point M may alternatively be below the first radiating element 111, below the second radiating element 112, or below the third radiating element 113.

Similarly, when the antenna array includes a subarray having three radiating elements, the feed point includes the foregoing arrangement positions, but is not limited to these arrangement positions.

When the antenna array includes a subarray having more radiating elements, a specific arrangement manner of the feed point M is similar to the foregoing arrangement example.

It may also be understood as that, when the antenna array includes a subarray having at least two radiating elements, a feed point is located between two adjacent radiating elements, or a feed point is located on a side that is of a radiating element at an end and that is away from a remaining radiating element, or a feed point is located below all radiating elements in the subarray.

To implement irregular arrangement of phase centers and regular arrangement of feed points, there is a vacant grid between two adjacent subarrays in some rows and some columns. As shown in FIG. 14, a dummy element (Dummy Element) 2 is disposed in the vacant grid. The dummy element is a non-feed radiating element.

Disposing the dummy element can make surrounding environments of all subarrays of the antenna array consistent, so that patterns of all the subarrays are basically consistent, and finally, a communication capacity of the antenna array is improved.

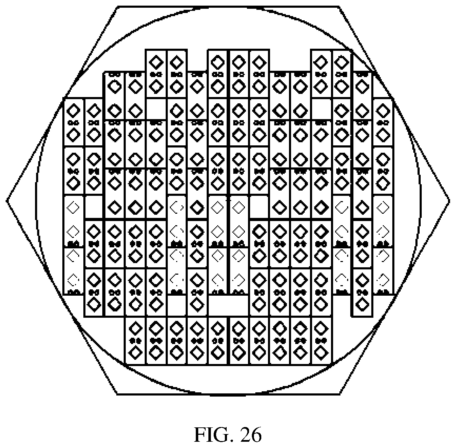

A two-dimensional shape formed by the antenna array provided in this application may be a rectangular array provided in FIG. 7 and FIG. 13, or may be a shape close to a circle shown in FIG. 25, or may be a polygon shape (such as a hexagon shown in FIG. 26).

In the descriptions of this specification, the described specific features, structures, materials, or characteristics may be combined in a proper manner in any one or more of embodiments or examples.

In the descriptions of this specification, "a plurality of" means two or more. For example, "a plurality of subarrays" may include three or more subarrays, "a plurality of radio frequency transmitting and receiving channels" may include two or more radio frequency transmitting and receiving channels, and "a plurality of RFIC chips" may include two or more RFIC chips, and the like.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. An antenna array, comprising:
a plurality of subarrays, wherein a feed point and at least one radiating element are disposed on each subarray, the plurality of subarrays are arranged in a first direction and a second direction, the first direction is perpendicular to the second direction, the feed points of the plurality of subarrays are located on a same straight line in the first direction, and the feed points of the plurality of subarrays are located on a same straight line in the second direction; and in the first direction, subarrays to which feed points on a same straight line belong are located in a same row, and in the second direction, subarrays to which feed points on a same straight line belong are located in a same column; and
each subarray has a phase center, phase centers of subarrays in at least one row of subarrays in the antenna array are not on a same straight line, and/or phase centers of subarrays in at least one column of subarrays in the antenna array are not on a same straight line.

2. The antenna array according to claim 1, wherein the antenna array comprises N subarrays, a same quantity of radiating elements are disposed on each of the N subarrays, a feed point of at least one of the N subarrays is different from a feed point of another subarray of the N subarrays, and N is an integer greater than or equal to 2.

3. The antenna array according to claim 1 or 2, wherein the antenna array comprises at least two types of same-type subarrays, and a same quantity of radiating elements are disposed on subarrays of one type of the same-type subarrays.

4. The antenna array according to any one of claims 1 to 3, wherein
the antenna array comprises at least one first subarray, at least two radiating elements are disposed on the first subarray, and the at least two radiating elements are arranged in a straight line; and
a feed point of the first subarray is located between the two radiating elements; or
the feed point of the first subarray is located on a side that is of a radiating element at an end of the first subarray and that is away from a remaining radiating element.

5. The antenna array according to any one of claims 1 to 4, wherein the antenna array comprises at least one second subarray, one radiating element is disposed on the second subarray, and a feed point of the second subarray is located beside the radiating element.

6. The antenna array according to any one of claims 1 to 5, wherein in the first direction, spacings between feed points of every two adjacent subarrays are equal, and/or in the second direction, spacings between feed points of every two adjacent subarrays are equal.

7. The antenna array according to any one of claims 1 to 6, wherein the antenna array comprises a dummy element, and the dummy element is a non-feed radiating element.

8. An apparatus, comprising:
the antenna array according to any one of claims 1 to 7,
a feeder cable, and
a circuit bearing board, wherein the feeder cable is configured to feed a subarray in the antenna array, and the antenna array and the feeder cable are disposed on the circuit bearing board.

9. The apparatus according to claim 8, further comprising:
at least one radio frequency integrated circuit chip, wherein the radio frequency integrated circuit chip is disposed on the circuit bearing board, the radio frequency integrated circuit chip comprises at least two radio frequency transmitting and receiving channels, the at least two radio frequency transmitting and receiving channels are configured to respectively feed at least two subarrays in the antenna array through the feeder cables, and the radio frequency transmitting and receiving channels are connected to the subarrays in a one-to-one manner.

10. The apparatus according to claim 9, wherein
the apparatus comprises a power divider/combiner and the at least two radio frequency integrated circuit chips, the power divider/combiner is separately connected to the at least two radio frequency integrated circuit chips through at least two power divider lines, the at least two power divider lines have a same length, and the power divider lines are connected to the radio frequency integrated circuit chips in a one-to-one manner.

11. The apparatus according to claim 10, wherein the circuit bearing board is a package substrate; and
the apparatus further comprises:
a printed circuit board, wherein the package substrate is disposed on the printed circuit board and is connected to the printed circuit board, and the power divider/combiner is disposed on the printed circuit board.

12. The apparatus according to claim 10, wherein the circuit bearing board is a printed circuit board; and the power divider/combiner is disposed on the printed circuit board.

13. An apparatus comprising:
the antenna array according to any one of claims 1 to 7;
a feeder cable; and
at least one radio frequency integrated circuit chip, wherein the antenna array and the feeder cable are disposed on a packaging layer of the radio frequency integrated circuit chip, the radio frequency integrated circuit chip comprises at least two radio frequency transmitting and receiving channels, the at least two radio frequency transmitting and receiving channels are configured to respectively feed at least two subarrays in the antenna array through the feeder cables, and the radio frequency transmitting and receiving channels are connected to the subarrays in a one-to-one manner.

14. The apparatus according to claim 13, wherein the apparatus comprises a power divider/combiner and at least two radio frequency integrated circuit chips; and
the power divider/combiner is separately connected to the at least two radio frequency integrated circuit chips through at least two power divider lines, the at least two power divider lines have a same length, and the power divider lines are connected to the radio frequency integrated circuit chips in a one-to-one manner.

15. The apparatus according to claim 13 or 14, wherein the apparatus further comprises:
a printed circuit board, wherein both the radio frequency integrated circuit chip and the power divider/combiner are disposed on the printed circuit board.

16. A wireless communication device, comprising:
the antenna array according to any one of claims 1 to 7, or the apparatus according to any one of claims 8 to 15.
